# EUROPÄISCHE PATENTANMELDUNG

(11) **EP 4 088 844 A1**
(43) Veröffentlichungstag der Anmeldung: **16.11.2022**
(21) Anmeldenummer: 22172750.6
(22) Anmeldetag: 11.05.2022
(51) Int. Cl.: B23C 3/34, B23P 15/26, B23C 3/30, B23C 5/08

(54) **KÜHLKÖRPER AUS METALL SOWIE VERFAHREN ZUR HERSTELLUNG DESSELBEN**

(30) Priorität: 12.05.2021 DE 102021112412
(71) Anmelder: Erwin Quarder Systemtechnik GmbH, 32339 Espelkamp (DE)
(72) Erfinder: Siewert, Georg, 35415 Pohlheim (DE); Heitbrink, Alexander, 32351 Stemwede (DE)
(74) Vertreter: Aulich, Martin

(57) **Zusammenfassung**

Die Erfindung betrifft einen Kühlkörper aus Metall, vorzugsweise aus einem massiven Metallblock, insbesondere aus Aluminium, sowie ein Verfahren und ein Werkzeug zur Herstellung desselben. Der Kühlkörper weist eine Mehrzahl von durch zwischen ihnen angeordnete Kühlkörperrippen (26) voneinander getrennten, nebeneinander angeordneten sowie parallel verlaufenden Fluidleitungen (32) zum Durchleiten von Kühlfluid auf. Er ist dadurch gekennzeichnet, dass die Fluidleitungen (32) durch Nuten (24) gebildet sind, die in das Metall eingefräst sind.

## Beschreibung

Die vorliegende Erfindung betrifft einen Kühlkörper aus Metall, insbesondere aus Aluminium, mit einer Mehrzahl durch zwischen ihnen angeordnete Kühlkörperrippen voneinander getrennten, nebeneinander angeordneten sowie parallel zueinander verlaufenden Fluidleitungen zum Durchleiten von Kühlfluid, sowie ein Verfahren und ein Werkzeug zum Einbringen von Nuten in ein Werkstück aus Metall, insbesondere im Rahmen der Herstellung eines solchen Kühlkörpers.

Derartige Kühlkörper aus Metall werden im Stand der Technik in verschiedener Weise hergestellt. Beispielsweise, indem auf einen Metallblock einzelne Kühlkörperrippen aufgeklebt werden. Weiter ist es unter anderem bekannt, solche Metallkörper mittels Druckgussverfahren, Extrudieren, Schmieden, Pressen oder Zerspanungsverfahren herzustellen.

Die jeweiligen Verfahren sind entweder sehr zeitintensiv oder in anderer Hinsicht aufwendig und daher entsprechend kostenintensiv oder die einzelnen Rippenkörper und Fluidleitungen können nicht ausreichend schmal ausgebildet werden, was zu einer flächenbezogen kleinen Wärmeaustauschfläche führt.

Ausgehend hiervon ist es Aufgabe der vorliegenden Erfindung, einen Kühlkörper der eingangs genannten Art weiterzuentwickeln sowie ein insbesondere im Rahmen der Herstellung eines solchen Kühlkörpers anwendbares bzw. verwendbares Verfahren und Werkzeug zum Einbringen von Nuten in ein Werkstück aus Metall anzugeben.

Diese Aufgabe wird gelöst durch einen Kühlkörper mit den Merkmalen des Anspruchs 1, ein Werkzeug mit den Merkmalen des Anspruchs 11 sowie ein Verfahren mit den Merkmalen des Anspruchs 21.

Ein erfindungsgemäßer (massiver) Kühlkörper, insbesondere hergestellt aus einem massiven Metallblock, zeichnet sich dementsprechend dadurch aus, dass die Fluidleitungen desselben durch Nuten gebildet sind, die in das Metall des Kühlkörpers eingefräst wurden bzw. eingefräst sind.

Es hat sich erfindungsgemäß überraschend gezeigt, dass das Einbringen einer Vielzahl von nebeneinander angeordneten Nuten in einen aus Metall bestehenden (massiven) Körper durch Frästechnik prozesstechnisch in der Anzahl und mit den Dimensionen möglich ist, wie dies für die Ausbildung eines leistungsfähigen Kühlkörpers erforderlich ist, sodass dieser Metallkörper dann als Kühlkörper verwendet werden kann, bei dem die Nuten die Fluidleitungen des Kühlkörpers bilden.

Die verwendete Frästechnik weist dabei gegenüber den eingangs erwähnten Lösungen des Standes der Technik erhebliche Prozessvorteile auf.

Die Nuten werden erfindungsgemäß mit einem um eine Drehachse rotierbaren Fräskopf hergestellt, der eine Mehrzahl von nebeneinander angeordneten, sich jeweils queraxial erstreckenden Fräsebenen aufweist, in denen jeweils Fräszähne angeordnet sind, wobei die Fräszähne benachbarter Fräsebenen in Axialrichtung voneinander beabstandet sind im Abstand benachbarter herzustellender Nuten, und wobei die Fräszähne entweder an in Axialrichtung nebeneinander angeordneten Frässcheiben angeordnet sind oder Teil einer Fräswalze sind.

Erfindungsgemäß kann der Fräskopf dann im Betrieb insbesondere durch einen Antriebsmotor in Rotation versetzt und an einen insbesondere massiven Metallblock bzw. Metallkörper herangeführt werden, aus dem dann der Kühlkörper gefertigt werden soll. Mit dem Fräskopf werden dann gleichzeitig eine der Anzahl der Fräsebenen des Fräskopfs entsprechende Anzahl der insbesondere Fluidleitungen bildenden Nuten in den Metallblock eingefräst.

Weitere Merkmale der vorliegenden Erfindung ergeben sich aus den beigefügten Patentansprüchen, der nachfolgenden Beschreibung bevorzugter Ausführungsbeispiele, sowie aus den beigefügten Zeichnungen.

Darin zeigt:
- Fig. 1a:: ein erfindungsgemäßes Werkzeug zur Herstellung eines erfindungsgemäßen Kühlköpers in Schrägansicht,
- Fig. 1b:: einen Teilbereich des Werkzeugs aus Fig. 1a in einem Querschnitt,
- Fig. 2:: eine Kühleinrichtung mit erfindungsgemäßen Kühlkörpern in Schrägansicht,
- Fig. 3:: einen Teilbereich eines der Kühlkörper der Kühleinrichtung aus Fig. 2 in einem Querschnitt, in den mit dem Werkzeug gemäß Fig. 1 Nuten eingebracht wurden.

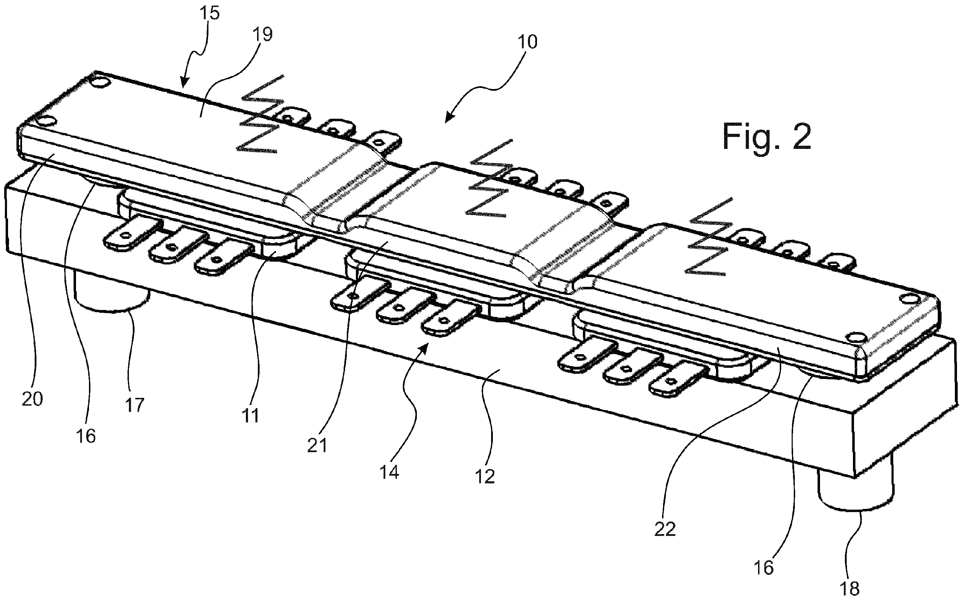

Die in der Fig. 2 gezeigte Kühleinrichtung 10 dient zum Abführen von Wärme von zu kühlenden Gegenständen 11, im vorliegenden Fall Leistungselektronikbauteilen (etwa Wechselrichtermodule), wie sie beispielsweise im Zusammenhang mit Batterien bzw. Akkus von Elektrofahrzeugen verwendet werden. Auf die Art der zu kühlenden Gegenstände kommt es erfindungsgemäß allerdings nicht an.

Die Kühleinrichtung 10 verfügt über einen unteren Kühlkörper 12, auf dem die zu kühlenden Gegenstände 11 angeordnet sind bzw. sitzen und der die Unterseiten der zu kühlenden Gegenstände 11 kühlt bzw. Wärme von diesen aufnimmt, sowie über mehrere, vorliegend drei, obere Kühlkörper 20, 21, 22, die jeweils an den Oberseiten der kühlenden Gegenstände 11 anliegen und diese kühlen bzw. Wärme von deren Oberseiten aufnehmen.

Der untere Kühlkörper 12 sowie die oberen Kühlkörper 20, 21, 22 sind vorliegend jeweils als massive Metallkörper ausgebildet, beispielsweise aus Aluminium.

Der untere Kühlkörper 12 ist Teil eines unteren Kühlbauteils 14, das im Inneren (nicht gezeigt) über einen Kühlfluidraum verfügt, der nach außen von dem unteren Kühlkörper 12 und einem beispielsweise aus Kunststoff hergestellten Grundkörper begrenzt wird, wobei der untere Kühlkörper 12 und der ihm zugeordnete Grundkörper fluiddicht, vorliegend flüssigkeitsdicht, miteinander verbunden sind (etwa stoffschlüssig). In den Figuren sind der untere Kühlkörper 12 des unteren Kühlbauteils 14 und dessen Grundkörper der Einfachheit halber zeichnerisch nicht einzeln aufgelöst, sondern vielmehr als Gesamteinheit bzw. Gesamtblock dargestellt.

Die oberen Kühlkörper 20, 21, 22 sind Teil eines oberen Kühlbauteils 15, das ebenfalls im Inneren über einen Kühlfluidraum verfügt, der nach außen einerseits von den oberen Kühlkörpern 20, 21, 22 und andererseits von einem beispielsweise ebenfalls aus Kunststoff hergestellten, diesen oberen Kühlkörpern 20, 21, 22 zugeordneten Grundkörper 19 begrenzt wird. Auch die oberen Kühlkörper 20, 21, 22 und der ihnen gemeinsam zugeordnete Grundkörper 19 des oberen Kühlbauteils 15 sind dabei fluiddicht, vorliegend ebenfalls flüssigkeitsdicht, miteinander verbunden (etwa stoffschlüssig).

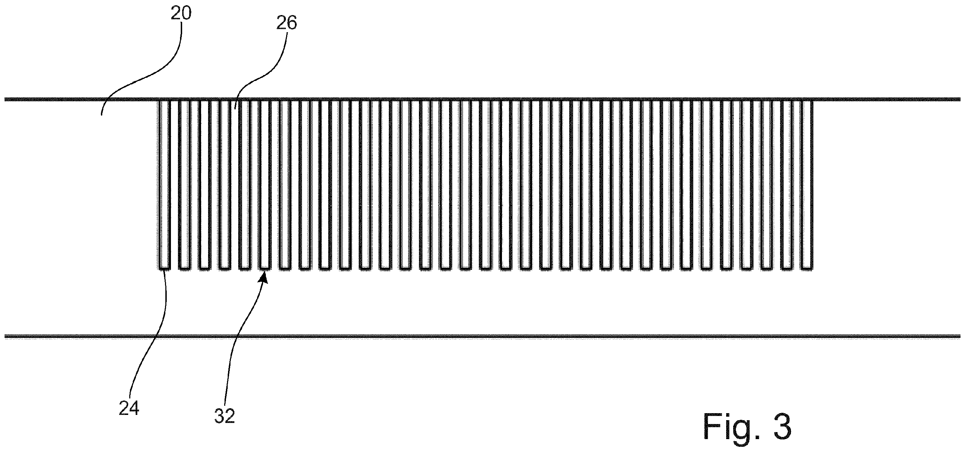

Ein oder beide Kühlfluidräume können beispielsweise aus einer Mehrzahl von in den jeweiligen Kühlkörpern 12 bzw. 20, 21, 22 eingebrachten Fluidleitungen 32 bestehen oder diese umfassen. In der Fig. 3 ist beispielhaft ein Ausschnitt eines Querschnitts durch den Kühlkörper 20 mit den Fluidleitungen 32 gezeigt.

Das untere Kühlbauteil 14 und das obere Kühlbauteil 15, genauer gesagt die Kühlfluidräume derselben, sind vorliegend über seitlich angeordnete, insbesondere senkrecht zu ihnen verlaufende Verbindungsleitungen 16 fluidleitend miteinander verbunden.

Die Kühleinrichtung 10 verfügt des Weiteren über einen Mediumeinlass 17 sowie einen Mediumauslass 18.

Im Ergebnis kann entsprechend über den Mediumeinlass 17 zunächst dem unteren Kühlbauteil 14 und in der Folge auch dem oberen Kühlbauteil 15 Kühlfluid zugeführt werden, das im Betrieb der Kühleinrichtung 10 die (Ab-)Wärme abführen kann, die die Kühlkörper 12 bzw. 20, 21, 22 von den zu kühlenden Gegenständen 11 aufnehmen.

In der Regel wird es sich bei dem Kühlfluid um eine Kühlflüssigkeit handeln. Es versteht sich aber, dass es auch im Rahmen der Erfindung liegt, als Kühlfluid ein gasförmiges Medium zu verwenden. Die entsprechenden fluiddichten Verbindungen zwischen dem jeweiligen Grundkörper und dem unteren bzw. oberen Kühlkörper 12 bzw. 20, 21, 22 etc. müssten dann entsprechend gasdicht ausgebildet sein.

Es versteht sich weiter, dass es erfindungsgemäß auf die oben beschriebene genaue Ausbildung der Kühlkörper 12, 20, 21, 22 und insbesondere auch der gesamten Kühleinrichtung 10 nicht ankommt und diese nur beispielhaft zu verstehen ist.

Bei den in die Kühlkörper 12, 20, 21, 22 eingebrachten Fluidleitungen 32 handelt es sich erfindungsgemäß um nebeneinander angeordnete Nuten 24, die unter Bildung von zwischen ihnen angeordneten Kühlkörperrippen 26 in die Kühlkörper 12, 20, 21, 22 bzw. in einen entsprechenden Metallblock bzw. Metallkörper, aus denen diese hergestellt sind, eingefräst worden sind.

Dies beispielsweise mittels eines in Fig. 3 gezeigten, nachfolgend noch näher beschriebenen, als Fräskopf 23 ausgebildeten (Fräs-)Werkzeugs, der entsprechend in einem Fräsprozess an den beispielsweise quaderförmigen Metallblock zum Einfräsen der Nuten 24 an diesen herangeführt wurde.

Die Nuten 24 verlaufen bevorzugt parallel zueinander. Jeweils zwei unmittelbar benachbarte Nuten 24 sind durch jeweils eine zwischen ihnen angeordnete Kühlkörperrippe 26 voneinander getrennt, deren Flächen die Wärmeaustauschflächen des jeweiligen Kühlkörpers 12, 20, 21, 22 bilden, über die das durch die Nuten 24 fließende Kühlfluid die von den Kühlkörpern 12, 20, 21, 22 aufgenommene Wärme aufnimmt und ableitet.

Die Kühlkörperrippen 26 sind durch diejenigen Materialbereiche des jeweiligen Metallblocks, aus dem die Kühlkörper 12, 20, 21, 22 hergestellt sind, gebildet, die von den Frässcheiben 25 des Fräskopfs 23 nicht bearbeitet wurden und entsprechend stehen geblieben sind.

Im vorliegenden Fall weisen sämtliche Nuten 24 und sämtliche Kühlkörperrippen 26 eine identische Breite auf. Dies muss aber nicht zwingend so sein.

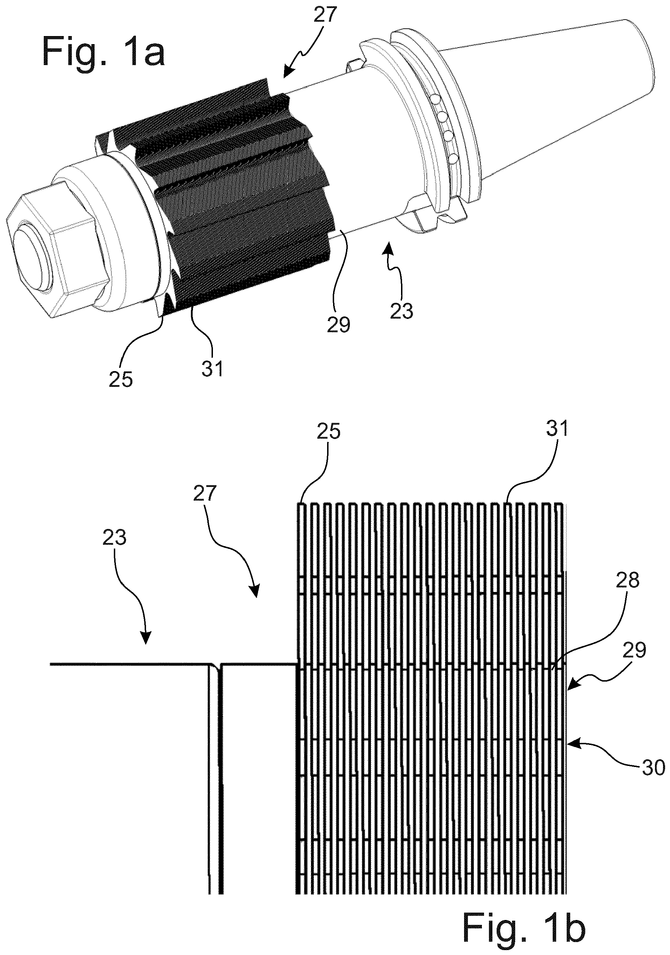

Was das in Fig. 1 gezeigte (Fräs-)Werkzeug bzw. den dort gezeigten Fräskopf 23 betrifft, so wird dieser im Betrieb an einer Aufnahme einer ansonsten nicht gezeigten Fräsmaschine befestigt, die Drehbewegungen eines Motors auf den Fräskopf 23 überträgt und diesen entsprechend in Drehungen um seine Drehachse versetzt.

Der Fräskopf 23 weist dabei einen Schaft 27 mit einem vorliegend zylindrischen Abschnitt 29 auf, der im Betrieb des Werkzeugs 23 in die Werkzeugaufnahme der Fräsmaschine eingespannt und in Drehbewegungen um seine Längsmittelachse versetzt wird.

Auf dem Schaft 27 bzw. auf dessen zylindrischem Abschnitt 29 ist eine Vielzahl von nebeneinander angeordneten, vorliegend ringartigen Frässcheiben 25 drehfest angeordnet, wobei jede Frässcheibe 25 jeweils über eine zentrale, vorliegend kreisrunde Frässcheibendurchgangsöffnung bzw. Frässcheibenbohrung 30 verfügt, in die der Schaft 27 jeweils eingeschoben ist bzw. durch die der Schaft 27 jeweils hindurchgeführt ist.

Die einzelnen, vorliegend eben bzw. plan ausgeführten Frässcheiben 25, insbesondere jeweils unmittelbar benachbarte Frässcheiben 25, sind jeweils in Axialrichtung voneinander beabstandet, bevorzugt im Bereich ihrer um den jeweiligen Umfang der Frässcheiben 25 verteilt angeordneten Fräszähne 31.

Allgemein gesprochen sind die Fräszähne 31 des Fräskopfs 23 in einzelnen, nebeneinander angeordneten, in Axialrichtung voneinander beabstandeten - vorliegend durch die Frässcheiben 25 definierten -, sich jeweils queraxial erstreckenden Fräsebenen angeordnet, wobei jeweils der axiale Abstand von in benachbarten Fräsebenen angeordneten Fräszähnen 31 jeweils dem Abstand der in den jeweiligen Kühlkörper 12, 20, 21, 22 eingebrachten Nuten 24 bzw. Fluidleitungen 32 entspricht.

Was die einzelnen Frässcheiben 25 des Fräskopfs 23 betrifft, so sind diese bevorzugt unter einer axialen Vorspannung drehfest mit dem Schaft 27 verbunden bzw. auf dem Schaft 27 angeordnet/befestigt, insbesondere unter einer Vorspannung von mindestens 150 kN.

Der jeweilige axiale Abstand zwischen den Fräszähnen 31 benachbarter Fräsebenen kann beispielsweise jeweils durch ein Distanzstück 28 bewirkt werden.

Im vorliegenden Fall ist als Distanzstück 28 jeweils eine separate, ringförmige Distanzscheibe vorgesehen, die jeweils auf dem Schaft 27 sitzt und zwar jeweils zwischen zwei benachbarten Frässcheiben 25.

Denkbar sind zur Herstellung der axialen Abstände zwischen den Fräszähnen 31 benachbarter Fräsebenen (die vorliegend, da die Frässcheiben 25 eben ausgebildet sind, den axialen Abständen benachbarter Frässcheiben 25 entsprechen) aber auch andere Lösungen.

So könnten die Distanzstücke 28 auch beispielsweise jeweils einstückig mit einer der beiden Frässcheiben 25 verbunden sein, zwischen denen es angeordnet ist.

In einer Alternative zu dem in der Fig. 1 gezeigten Fräskopf 23 könnten im Übrigen auch sämtliche Frässcheiben 25 untereinander über Distanzstücke 28 einstückig miteinander verbunden sein, sodass eine Art Fräswalze entstehen würde.

In einer anderen Weiterbildung dieses Konzepts könnte eine solche oder eine andere Form von Fräswalze auch einen zylindrischen Kern mit zentraler (Längs-)Bohrung aufweisen, der auf den Schaft 27 geschoben wird und einstückig mit entsprechend mit (axialen) Abständen in den queraxialen Fräsebenen angeordneten Fräszähnen 31 verbunden ist.

Was die Anordnung der Fräszähne 31 im Übrigen betrifft, so könnte - anders als in Fig. 1 gezeigt - auch vorgesehen sein, dass Fräszähne 31, die in einer ersten Gruppe von Fräsebenen angeordnet sind, gegenüber Fräszähnen 31, die in einer zweiten Gruppe von Fräsebenen angeordnet sind, in Umfangsrichtung versetzt zueinander angeordnet sind, insbesondere derart, dass ein gleichzeitiger Eingriff der Fräszähne 31 der einen und der anderen Gruppe in das zu bearbeitende Werkstück bzw. den entsprechenden Metallblock/Metallkörper vermeidbar ist oder vermieden wird.

Es hat sich gezeigt, dass bestimmte Parameter der Nuten 24 bzw. der Kühlkörperrippen 26 für die Wärmeübertragung des Kühlkörpers 12, 20, 21, 22 besonders günstig (wenn auch nicht zwingend) sind:
Die Nuten 24 sollten vorzugsweise jeweils eine Tiefe zwischen 1 mm und 20 mm aufweisen, besonders bevorzugt zwischen 4 mm und 15 mm.

Die Eindringtiefe der Fräszähne 31 des Fräskopfs 23 kann dabei entsprechend dieselben Werte erfüllen.

Weiter vorzugsweise sollten die Nuten 24 eine Breite zwischen 0,1 mm und 2 mm, besonders bevorzugt zwischen 0,2 mm und 0,8 mm aufweisen.

Die Breite der Fräszähne 31 des Fräskopfs 23 und/oder die Breite der Frässcheiben 25, die die Breite der Nuten 24 bestimmt, kann dann entsprechend jeweils ebenfalls einen Wert zwischen 0,1 mm und 2 mm aufweisen, besonders bevorzugt zwischen 0,2 mm und 0,8 mm.

Vorzugsweise sollten die zwischen den Nuten 24 angeordneten Kühlkörperrippen 26 jeweils eine Breite zwischen 0,1 mm und 2 mm aufweisen, besonders bevorzugt zwischen 0,2 mm und 0,8 mm.

Die entsprechenden axialen Abstände der in benachbarten Fräsebenen angeordneten Fräszähne 31 und/oder Frässcheiben 25, die diese axialen Abstände zwischen benachbarten, erzeugbaren Nuten 24 bestimmen bzw. die Breite der Kühlkörperrippen 26, kann dann ebenfalls jeweils einen Wert zwischen 0,1 mm und 2 mm aufweisen, besonders bevorzugt zwischen 0,2 mm und 0,8 mm.

Vorzugsweise sollte die Breite sämtlicher eingefräster Nuten 24 identisch sein.

Entsprechend kann die Breite der Fräszähne 31 sämtlicher Fräsebenen ebenfalls identisch sein.

Vorzugsweise sollte die Breite der Nuten 24 der Breite der zwischen ihnen angeordneten Kühlkörperrippen 26 entsprechen.

Entsprechend kann dann die Breite der Fräszähne 31 und die Breite der axialen Abstände zwischen den in benachbarten Fräsebenen angeordneten Fräszähnen 31 und/oder der Frässcheiben 25, ebenfalls identisch sein.

Was die Anzahl der in den Kühlkörper 12, 20, 21, 22 eingefrästen Nuten 24 betrifft, so sollte diese zwischen 5 und 150, besonderes bevorzugt zwischen 10 und 100 betragen.

Entsprechendes kann dann für den Fräskopf 23 gelten, der zwischen 5 und 150, besonderes bevorzugt zwischen 10 und 100 von nebeneinander angeordneten, insbesondere durch die Frässcheiben 25 bzw. die Fräszähne 31 der Frässcheiben 25 definierte Fräsebenen aufweisen sollte, in denen die Fräszähne 31 jeweils angeordnet sind.

Die Anzahl nebeneinander angeordneter Kühlkörperrippen 26 pro cm Kühlkörperbreite sollte bevorzugt zwischen 2,5 und 50 liegen, besonders bevorzugt zwischen 6,25 und 25.

Für sämtliche der nebeneinander angeordneten Nuten 24 des Kühlkörpers 12, 20, 21, 22 gilt, vgl. oben, gilt im Übrigen, dass jeweils zwei benachbarte Nuten 24 durch eine zwischen ihnen angeordnete Kühlkörperrippe 26 getrennt sein sollten.

### Bezugszeichenliste:

- 10: Kühleinrichtung
- 11: zu kühlender Gegenstand
- 12: unterer Kühlkörper
- 14: unteres Kühlbauteil
- 15: oberes Kühlbauteil
- 16: Verbindungsleitung
- 17: Mediumeinlass
- 18: Mediumauslass
- 19: Grundkörper oberes Kühlbauteil
- 20: oberer Kühlkörper
- 21: oberer Kühlkörper
- 22: oberer Kühlkörper
- 23: Fräskopf
- 24: Nuten
- 25: Frässcheiben
- 26: Kühlkörperrippen
- 27: Schaft
- 28: Distanzstück
- 29: zylindrischer Abschnitt
- 30: Frässcheibenbohrung
- 31: Fräszähne
- 32: Fluidleitungen

## Patentansprüche

1. Kühlkörper aus Metall, vorzugsweise aus einem massiven Metallblock, insbesondere aus Aluminium, mit einer Mehrzahl durch zwischen ihnen angeordnete Kühlkörperrippen (26) voneinander getrennten, nebeneinander angeordneten sowie parallel verlaufenden Fluidleitungen (32) zum Durchleiten von Kühlfluid, **dadurch gekennzeichnet, dass** die Fluidleitungen (32) durch Nuten (24) gebildet sind, die in das Metall eingefräst sind.

2. Kühlkörper gemäß Anspruch 1, **dadurch gekennzeichnet, dass** die Nuten (24) jeweils eine Tiefe zwischen 1 mm und 20 mm aufweisen, besonders bevorzugt zwischen 4 mm und 15 mm, und/oder dass die Nuten (24) jeweils eine Breite zwischen 0,1 mm und 2 mm aufweisen, besonders bevorzugt zwischen 0,2 mm und 0,8 mm.

3. Kühlkörper gemäß einem oder mehreren der vorhergehenden Ansprüche, **dadurch gekennzeichnet, dass** die zwischen den Nuten (24) angeordneten Kühlkörperrippen (26) jeweils eine Breite von 0,1 mm und 2 mm aufweisen, besonders bevorzugt zwischen 0,2 mm und 0,8 mm, und/oder dass die Breite sämtlicher eingefräster Nuten (24) identisch ist, und/oder dass die Breite der Nuten (24) der Breite der zwischen ihnen angeordneten Kühlkörperrippen (26) entspricht.

4. Kühlkörper gemäß einem oder mehreren der vorhergehenden Ansprüche, **dadurch gekennzeichnet, dass** die Anzahl der in den Kühlkörper eingefrästen Nuten (24) zwischen 5 und 150, besonderes bevorzugt zwischen 10 und 100 beträgt, und/oder dass die Anzahl nebeneinander angeordneter Kühlkörperrippen (26) pro cm Kühlkörperbreite zwischen 2,5 und 50 liegt, besonders bevorzugt zwischen 6,25 und 25.

5. Kühlkörper gemäß einem oder mehreren der vorhergehenden Ansprüche, **dadurch gekennzeichnet, dass** für sämtliche der nebeneinander angeordneten Nuten (24) des Kühlkörpers gilt, dass jeweils zwei benachbarte Nuten (24) durch eine zwischen ihnen angeordnete Kühlkörperrippe (26) getrennt sind.

6. Kühlkörper gemäß einem oder mehreren der vorhergehenden Ansprüche, **dadurch gekennzeichnet, dass** der Kühlkörper ein insbesondere quaderförmiger, massiver Metallblock ist, in den die Nuten (24) eingefräst sind.

7. Werkzeug zum Einbringen einer Mehrzahl von benachbarten Nuten (24) in ein vorzugsweise massives Werkstück aus Metall, bevorzugt Aluminium, insbesondere im Rahmen der Herstellung eines Kühlkörpers aus Metall mit durch die Nuten (24) gebildeten, durch Kühlkörperrippen (26) getrennten Fluidleitungen (32) zum Durchleiten von Kühlfluid gemäß einem oder mehreren der vorhergehenden Ansprüche, wobei das Werkzeug einen um eine Drehachse rotierbaren Fräskopf (23) mit einer Mehrzahl nebeneinander angeordneten, sich jeweils queraxial erstreckenden Fräsebenen aufweist, in denen jeweils Fräszähne (31) angeordnet sind, wobei die Fräszähne (31) benachbarter Fräsebenen in Axialrichtung voneinander beabstandet sind im Abstand benachbarter herzustellender Nuten (24), und wobei die Fräszähne (31) entweder an in Axialrichtung nebeneinander angeordneten Frässcheiben des Fräskopfs (23) angeordnet sind oder Teil einer Fräswalze des Fräskopfs (23) sind.

8. Werkzeug gemäß Anspruch 7, **dadurch gekennzeichnet, dass** der Fräskopf (23) zwischen 5 und 150, besonderes bevorzugt zwischen 10 und 100 von nebeneinander angeordneten, insbesondere durch die Frässcheiben bzw. die Fräszähne (31) der Frässcheiben definierten Fräsebenen aufweist, in denen Fräszähne (31) angeordnet sind, und/oder dass die Breite der Fräszähne (31) und/oder die Breite der Frässcheiben, die die Breite jeweils erzeugbarer Nuten (24) bestimmt, jeweils einen Wert zwischen 0,1 mm und 2 mm aufweist, besonders bevorzugt zwischen 0,2 mm und 0,8 mm.

9. Werkzeug gemäß Anspruch 7 oder 8, **dadurch gekennzeichnet, dass** die axialen Abstände von in benachbarten Fräsebenen angeordneten Fräszähnen (31) und/oder Frässcheiben, die die axialen Abstände zwischen benachbarten, erzeugbaren Nuten (24) bestimmen, jeweils einen Wert zwischen 0,1 mm und 2 mm aufweisen, besonders bevorzugt zwischen 0,2 mm und 0,8 mm, und/oder dass die Frässcheiben nebeneinander auf einem Schaft (27) des Fräskopfs (23) drehfest angeordnet sind, um dessen Längsmittelachse der Fräskopf (23) im Betrieb rotierbar ist bzw. rotiert wird, insbesondere auf einem zylindrischen Abschnitt (29) des Schafts (27).

10. Werkzeug gemäß einem oder mehreren der vorhergehenden Ansprüche 7-9, **dadurch gekennzeichnet, dass** jeweils auf dem Schaft (27) benachbart angeordnete Frässcheiben in Axialrichtung voneinander beabstandet sind durch ein zwischen ihnen angeordnetes, insbesondere ringförmiges Distanzstück (28), vorzugsweise durch ein Distanzstück (28), das ein separater, auf dem Schaft (27) sitzender Distanzring ist.

11. Werkzeug gemäß Anspruch 10, **dadurch gekennzeichnet, dass** das Distanzstück einstückig mit einer oder beiden der benachbarten Frässcheiben verbunden ist.

12. Werkzeug gemäß einem oder mehreren der vorhergehenden Ansprüche 7-11, **dadurch gekennzeichnet, dass** die Fräszähne (31), die in einer ersten Gruppe von Fräsebenen angeordnet sind, gegenüber den Fräszähnen (31), die in einer zweiten Gruppe von Fräsebenen angeordnet sind, in Umfangsrichtung versetzt angeordnet sind, insbesondere derart, dass ein gleichzeitiger Eingriff der Fräszähne (31) der einen und der anderen Gruppe in das zu bearbeitende Werkstück vermeidbar ist oder vermieden wird.

13. Werkzeug gemäß einem oder mehreren der vorhergehenden Ansprüche 7-12, **dadurch gekennzeichnet, dass** die einzelnen Frässcheiben unter einer axialen Vorspannung auf dem Schaft (27) befestigt sind, insbesondere unter einer Vorspannung von mindestens 150 kN.

14. Verfahren zum Einbringen einer Mehrzahl von benachbarten Nuten (24) in ein insbesondere massives Werkstück aus Metall, insbesondere im Rahmen der Herstellung eines Kühlkörpers aus Metall, bevorzugt aus Aluminium, mit einer Mehrzahl von durch Kühlkörperrippen (26) getrennten, nebeneinander angeordneten sowie parallel verlaufenden Fluidleitungen (32) zum Durchleiten von Kühlfluid, vorzugsweise gemäß einem oder mehreren der vorhergehenden Ansprüche, wobei mittels eines um eine Drehachse rotierenden Fräskopfs (23), der in einer Mehrzahl nebeneinander angeordneten, queraxialen Fräsebenen jeweils Fräszähne (31) aufweist, wobei die Fräszähne (31) benachbarter Fräsebenen in Axialrichtung voneinander beabstandet sind im Abstand benachbarter herzustellender Nuten (24), gleichzeitig eine der Anzahl der Fräsebenen entsprechende Anzahl von insbesondere Fluidleitungen (32) bildenden Nuten (24) in das insbesondere als massiver Metallblock ausgebildete Werkstück eingefräst werden.

15. Verfahren gemäß Anspruch 14, **gekennzeichnet durch** ein oder mehrere Merkmale der Ansprüche 1-13.
